# EUROPÄISCHE PATENTSCHRIFT

(11) **EP 3 579 408 B1**
(45) Veröffentlichungstag und Bekanntmachung des Hinweises auf die Patenterteilung: **28.12.2022**
(21) Anmeldenummer: 19175941.4
(22) Anmeldetag: 22.05.2019
(51) Int. Cl.: H03B 11/02, F41H 13/00

(54) **STRAHLUNGSQUELLE FÜR MIKROWELLEN-PULSE UND STRAHLUNGSEINRICHTUNG**
RADIATION SOURCE FOR MICROWAVE PULSE AND RADIATING DEVICE
SOURCE DE RAYONNEMENT POUR IMPULSIONS DE MICRO-ONDES ET DISPOSITIF DE RAYONNEMENT

(30) Priorität: 08.06.2018 DE 102018004568
(43) Veröffentlichungstag der Anmeldung: 11.12.2019
(73) Patentinhaber: Diehl Defence GmbH & Co. KG, 88662 ÜBERLINGEN (DE)
(72) Erfinder: Stark, Robert, 91438 Bad Windsheim (DE); Hertel, Martin, 91207 Lauf (DE)
(74) Vertreter: Diehl Patentabteilung

(56) Entgegenhaltungen:
- EP-A2- 2 397 809
- DE-A1-102006 014 230
- GB-A- 619 958
- US-A- 3 390 333
- US-A1- 2004 190 214
- US-A1- 2005 231 041
- US-A1- 2012 098 607
- US-A1- 2018 058 826
- SOKOLOV A A ET AL: "Test and Standard Sources of Electromagnetic Pulses", ULTRAWIDEBAND AND ULTRASHORT IMPULSE SIGNALS, THE THIRD INTERNATIONAL CONFERENCE, IEEE, PI, 30. September 2006 (2006-09-30), Seiten 60-65, XP031046649, DOI: 10.1109/UWBUS.2006.307159 ISBN: 978-1-4244-0513-8

## Beschreibung

Die Erfindung betrifft eine Strahlungsquelle zur Abstrahlung eines elektromagnetischen HPEM-Mikrowellen-Pulses (High-Power-Electro-Magnetics) und eine Strahlungseinrichtung mit der Strahlungsquelle und einer Steuereinrichtung.

HPEM-Wirksysteme bieten unter anderem die Möglichkeit, gezielt Störimpulse in unterschiedlichste elektronische Systeme zu lenken, um deren Funktionsfähigkeit zu blockieren.

Diese Produkte eröffnen die Chance, Einsatzkräfte vor Sprengfallen (IED = Improvised Explosive Devices) zu schützen, Fluchtfahrzeuge im fließenden Verkehr ohne Anwendung physischer Gewalt und dauerhafter Schädigung der Elektronik zu stoppen sowie die unberechtigte Zufahrt zu Sicherheitsbereichen zu verhindern. Darüber hinaus bietet ein HPEM-Effektor die Fähigkeit zur Abwehr kleiner, unbemannter Fluggeräte.

Ein HPEM-DS-Wirksystem (damped sinusoid) ist z. B. aus der EP 2 144 363 B1 bekannt.

Aus der US 2012/0098607 A1 ist eine modulare Mikrowellenquelle bekannt, die einen neuartigen elektromagnetischen Oszillator umfasst, der auf einer modifizierten Blumlein-Architektur mit einer integrierten Antenne basiert. In einer oder mehreren Ausführungsformen umfasst die Erfindung ein dreifaches Blumlein, in dem die Platten konfiguriert und angeordnet sind, um als Wellenleiter und Antenne zu wirken. In einer oder mehreren Ausführungsformen sind photoleitende Halbleiterschalter zwischen der Mittelplatte und einer oder beiden der oberen und unteren Platte angeordnet, um als Hochgeschwindigkeitsschalter zu wirken.

Aus der EP 2 397 809 A2 ist ein Verfahren sowie eine Anordnung zum Erzeugen von Mikrowellen-Impulsen hoher Energie, insbesondere auf Basis der HPEM-Technologie, bekannt. Zur Lösung der Aufgabe, einerseits die Energiedichte von Impulsen zu erhöhen, andererseits die Kompaktheit der betreffenden Geräte noch zu steigern, schlägt die vorliegende Erfindung vor, im Bereich der Antenne eine großflächige Anordnung einer Vielzahl von vorzugsweise nichtlinearen Halbleiterbauelementen zur Impulsformung einzusetzen.

Aus der US 2004/0190214 A1 ist es bekannt, dass die Überlagerung der Mikrowellenfelder einer Anordnung von Mikrowellengeneratoren mit selbstzündenden Funkenstrecken zur Entladung von Speichervorrichtungen, die auf eine hohe Spannung aufgeladen werden, zu einer Erhöhung der Feldstärke und der Fähigkeit zur Beeinflussung des Frequenzspektrums des emittierten Hochenergie-Hochfrequenzfeldes und seiner Emissionsrichtung führt.

Aus der GB 619,958 ist Ultrahochfrequentes elektromagnetisches Funkenoszillationssystem bekannt, umfassend, in Kombination, einen elektromagnetischen Funkenoszillator, eine Ladeschaltung umfassend eine Leistungsquelle, einen Luftkerntransformator, dessen Sekundärseite mit dem Funkenoszillator verbunden ist, einen Kondensator und einen Widerstand alle in Reihe miteinander, eine gittergesteuerte Gasentladungsröhre, deren Anode durch den Widerstand mit der Leistungsquelle auf einer Seite davon verbunden ist und deren Kathode mit der Leistungsquelle auf der anderen Seite davon verbunden ist, und Mittel zum Zuführen eines Potentials zu dem Gitter bei vorbestimmten Zeiten, um die Schaltung zu betreiben.

Aus der US 2005/0231041 A1 ist ein gerichtetes Energiesystem bekannt, das mehrere nicht kohärente Mikrowellenquellen und mehrere Antennen umfasst. Jede Antenne kann mit einer entsprechenden oder mehreren der Quellen gekoppelt sein, um Energie von den Quellen abzustrahlen und kumulativ Hochenergieimpulse zu erzeugen, die auf einer statistischen Kombination der von den Antennen abgestrahlten Energie basieren.

Aus "A. A. Sokolov and K. Y. Sakharov, "Test and Standard Sources of Electromagnetic Pulses," 2006 3rd International Conference on Ultrawideband and Ultrashort Impulse Signals, Sevastopol, 2006, pp. 60-65, doi: 10.1109/ UWBUS. 2006. 307159" sind Ergebnisse und Perspektiven von Entwicklungen und Untersuchungen elektromagnetischer Pulsquellen für Test- und Messzwecke bei Pulsdauern bis zu mehreren zig Picosekunden bekannt.

Aus der US 2018/0058826 A1 ist es bekannt, Breitband-GW (10⁺⁹ Watt), Spitzenleistung zu kombinieren, um MV/m (10⁺⁶ Volt/Meter), und GV/m (10⁺⁹ Volt/Meter), abgestrahlte E-Felder zu erzielen, im Bereich des Luft- oder Vakuumdurchbruchs im gesamten elektromagnetischen Spektrum, einschließlich optischer Frequenzen und darüber hinaus. Die Verwendung vieler Antennen und unabhängig getriggerter Generatoren ermöglicht das Erreichen eines GV/m-Feldes, während durch das Verhindern des durch das E-Feld induzierten Zusammenbruchs eine Kontrolle der Spitzenleistung und des Energieinhalts an den Zielen bereitgestellt wird. Die erreichten Breitband-MV/m-E-Feldpegel und die Energiedichte übersteigen deutlich die Werte, die für die Zerstörung entfernter elektronischer Ziele erforderlich sind; daher wird die Wirksamkeit der elektromagnetischen Waffen radikal verbessert. Darüber hinaus ermöglicht die Kollimation einer Vielzahl von MV/m-Strahlen das Erreichen eines GV/m-E-Felds, das um Größenordnungen den Luft- oder Vakuumdurchbruch übersteigt, der für eine Breitbandplasmaanregung bei Resonanzplasmafrequenzen im 300-GHz-Bereich erforderlich ist, was eine energieeffiziente Plasmaforschung ermöglicht, die zur Fusion führt.

Aus dem Patent US 3,390,333 sind parallele Verstärker bekannt mit Eingangs- und Ausgangskopplung durch dicht gepackte, elektrisch kleine Eingangs- und Ausgangsstrahler.

Aufgabe der vorliegenden Erfindung ist es, eine verbesserte Strahlungsquelle zur Abstrahlung eines elektromagnetischen HPEM-Mikrowellen-Pulses und eine verbesserte Strahlungseinrichtung vorzuschlagen.

Die Aufgabe wird gelöst durch eine Strahlungsquelle gemäß Patentanspruch 1 zur Abstrahlung eines elektromagnetischen HPEM-Mikrowellen-Pulses. Bevorzugte oder vorteilhafte Ausführungsformen der Erfindung sowie anderer Erfindungskategorien ergeben sich aus den weiteren Ansprüchen, der nachfolgenden Beschreibung sowie den beigefügten Figuren.

Die Strahlungsquelle enthält einen Mikrowellen-Generator zur Erzeugung des Pulses. Der Generator weist eine Generatoröffnung zur Ausgabe bzw. Abstrahlung des Pulses auf. Der Generator ist insbesondere ein DS-Generator (damped sinusoid). Die Strahlungsquelle enthält weiterhin eine Hornstruktur zur Formung des Pulses. Die Hornstruktur weist eine Eingangsöffnung auf. Die Eingangsöffnung ist mit der Generatoröffnung verbunden; insbesondere fallen Generatoröffnung und Eingangsöffnung zusammen. Die Eingangsöffnung dient zur Einstrahlung des vom Generator erzeugten Pulses. Die Hornstruktur weist außerdem eine Abstrahlöffnung auf. Diese dient zur Abstrahlung des geformten Pulses aus der Hornstruktur bzw. aus der Strahlungsquelle. Der Generator weist mindestens zwei Pulsquellen auf. Jede der Pulsquellen dient zur jeweiligen Erzeugung eines Pulsanteils. Der Puls ist die Summe bzw. Überlagerung der Pulsanteile.

Die Eingangsöffnung bildet also ein erstes "Ende" der Hornstruktur, durch die der noch ungeformte Puls in die Hornstruktur eintritt. In der Hornstruktur findet die Pulsformung statt. Die Abstrahlöffnung bildet das andere Ende der Hornstruktur, an welchem der geformte Puls aus dieser austritt. Die "Summe" der Pulsanteile wird in Form einer Überlagerung gebildet. Die Strahlungsquelle weist eine Zentralrichtung bzw. Mittellängsachse oder -linie auf. Der Puls wird im Betrieb der Strahlungsquelle in einer Abstrahlrichtung abgestrahlt. Die Zentralrichtung ist insbesondere die oder eine mittlere Abstrahlrichtung für Pulse aus der Abstrahlöffnung. Die "Abstrahlrichtung" stellt dabei insbesondere die Richtung eines Zentralstrahles bzw. eine Hauptrichtung der Abstrahlung (z. B. mit der größten Strahlungsdichte), eine - z. B. geometrische - Mittelrichtung der Abstrahlung o. ä. für den Puls dar. Insbesondere innerhalb der Strahlungsquelle kann die Zentralrichtung dabei insbesondere eine gerade, aber auch eine zumindest abschnittsweise gekrümmte bzw. abgewinkelte Linie sein. Die Zentralrichtung ist eine feste bzw. konstruktive Eigenschaft der Anordnung. Die Abstrahlrichtung eine Eigenschaft des Pulses. Letztere kann auch variieren, wenn die Anordnung zur Strahlablenkung ausgebildet ist (s. u.). Insbesondere kann die Abstrahlrichtung dann ausgehend von der Zentralrichtung schräggestellt werden. Die mindestens zwei Pulsquellen werden dabei als "Array" von Pulsquellen bezeichnet.

Die Hornstruktur kann jede nach Art eines Mikrowellenhorns geformte Struktur sein. Insbesondere ein für den betreffenden Zweck geeignetes, aus der Praxis bekanntes bzw. übliches "Horn" bzw. jede "Hornantenne" für Mikrowellenanwendungen. Beim Durchlaufen der Hornstruktur wird der Puls dabei in bekannter Weise geformt, insbesondere gebündelt, gelenkt, konzentriert usw.

Gemäß der Erfindung ergeben sich folgende Vorteile: Durch die synergetisch Nutzung beider Technologien (Hornantennentechnik und Arraytechnologie) lässt sich die eingekoppelte Leistung und damit die "Leistungsdichte" respektive die abgestrahlte Leistung und damit die Reichweite bei vorgegebener Aperturfläche (Fläche der Abstrahlungsöffnung) und/oder Hornlänge (Länge des Horns entlang der Hornschenkel) von HPEM Wirksystemen im Vergleich zu einem System mit einer einzigen Pulsquelle ((DS-)Resonator/Antenne/Dipol/Monopol/Stub) deutlich erhöhen. Die Technologie kann angewendet werden, um die Leistung respektive die Reichweite von HPEM Systemen vorgegebener Größe deutlich zu erhöhen und/oder die Größe eines HPEM Systems bei vorgegebener Reichweite deutlich zu verkleinern und/oder die Reichweite mit zusätzlich zunehmender Größe überproportional zu steigern.

Gemäß der Erfindung erfolgt die Kombination der beiden Technologien zu einer neuen Gesamtsystemtechnologie. Die Nutzung der Wechselwirkungsbeziehungen zwischen dem Array-Konzept und dem Horn-Konzept in einem gemeinsamen System für HPEM-Anwendungen ist sehr komplex und neu und ermöglicht bei HPEM-DS-Systemen völlig neue Perspektiven in der Realisierung von HPEM-DS-Wirksystemen großer Reichweiten. Der Betrieb der Pulsquellen erfolgt insbesondere phasensynchron/gleichphasig, so dass sich abgestrahlte Wellen konstruktiv überlagern.

Gemäß der Erfindung ergeben sich weiterhin folgende Vorteile bzw. Anwendungsmöglichkeiten:
- Steigerung der Reichweite von HPEM-Systemen für verschiedene Anwendungen (z. B. Counter-UAS (unmanned aerial system), Feldlagerschutz, Stoppen von Booten/Schiffen).
- Erhöhung der Leistungsdichte und damit der Integrationsfähigkeit in unterschiedliche Plattformen bei vorgegebener Reichweite/Leistung.
- Anwendung des Prinzips auf ein oder mehrere Speisehörner von Parabolantennen zur Steigerung der eingekoppelten Leistung, respektive der Reichweite.

In einer bevorzugten Ausführungsform der Erfindung enthält wie oben bereits angedeutet die Pulsquelle einen Resonator und/oder eine Antenne und/oder einen Stub zur Erzeugung des Pulsanteils. Alternativ ist die Pulsquelle ein derartiges Element. Die Vorteile der Einzelelemente können so auch für die Strahlungsquelle genutzt werden.

In einer bevorzugten Ausführungsform enthält der Generator und/oder die Hornstruktur einen Wellenleiter (Waveguide) zur Führung der Pulsanteile und/oder des Pulses und/oder zur Summation der Pulsanteile. Der Wellenleiter weist insbesondere die Generatoröffnung auf, d. h. erstreckt sich bis zu dieser hin. Der Wellenleiter weist insbesondere die Eingangsöffnung auf, d. h. erstreckt sich ab dieser. Insbesondere ist mindestens eine, insbesondere alle Pulsquellen in einem der Wellenleiter angeordnet oder an diesen angeschlossen. Die Pulsanteile oder der Plus werden im Betrieb also entweder nach deren Erzeugung in den Wellenleiter eingekoppelt oder in diesem erzeugt. Insbesondere weist die Strahlungsquelle eine Zusammenschaltung mehrerer Einzel-Wellenleiter bzw. entsprechender Wellenleiterabschnitte auf. Mithilfe von Wellenleitern können die HF Pulse besonders effektiv geführt, umgelenkt, bearbeitet usw. werden.

In einer bevorzugten Ausführungsform ist daher mindestens eine der Pulsquellen in einem der Wellenleiter angeordnet. Dies führt zu einer besonders kompakten Ausführungsform des Generators mit integriertem Wellenleiter.

In einer bevorzugten Ausführungsform weist der Generator und/oder die Hornstruktur und/oder - falls ein solcher vorhanden ist - mindestens einer der Wellenleiter bezüglich der oben erläuterten Zentralrichtung der Strahlungsquelle einen eckigen Querschnitt auf. Insbesondere handelt es sich um eine Dreieck-, Viereck-, Rechteck-, Quadrat- oder Mehreckstruktur. Alternativ sind auch runde, Kreis-, Oval-, oder sonstige beliebige andere Formen denkbar. Derartige Formen haben sich in der Praxis als geeignet für HPEM-Pulse erwiesen.

In einer nicht zur Erfindung gehörenden Ausführungsform weist der Generator einen durchgehenden Innenraum auf, in dem die Pulsquellen angeordnet sind. Der Innenraum ist also ein insgesamt durchgängiger Hohlraum ohne Trennwände, Innenwände, Abteilungen usw. der Generator ist damit einfach zu konstruieren und zu fertigen. Insbesondere sind auf den jeweiligen Verbindungslinien zwischen jeweiligen Pulsquellen keine Trennwände o. ä. vorhanden, sondern nur freier (Luft-)Raum.

In einer bevorzugten Ausführungsform ist der - insbesondere durchgehende - Innenraum topf- oder kistenartig ausgebildet. Die einzigen den Generator zum Außenraum hin begrenzenden Wände sind also als Teil eines an einer Seite offenen Quaders oder Zylinders ausgebildet. Insbesondere ist ein der Generatoröffnung gegenüberliegender Boden des Generators eben oder gewölbt ausgeführt. Die den Boden mit der Generatoröffnung verbindenden (insbesondere eine, zwei, drei oder vier kantenfreie) Wände sind insbesondere zumindest abschnittsweise gerade oder sich zur Generatoröffnung hin erweiternd, insbesondere konisch, geformt. Die Generatoröffnung bildet damit eine Topf- oder Kistenöffnung des nur an dieser einen Seite offenen Topfes oder einer solchen Kiste. Alle anderen Wände sind geschlossen. Derartige Formen lassen sich besonders einfach konstruieren und fertigen und haben sich in der Praxis für die HPEM-Anwendung bewährt.

In einer bevorzugten Ausführungsform sind mindestens zwei, insbesondere mindestens drei oder vier, der Pulsquellen entlang einer Linie im Generator angeordnet. Die Linie verläuft insbesondere quer zur Abstrahlrichtung. Somit ergibt sich eine besonders einfache und effektive Quellenstruktur bzw. ein Linien-Array. Die Pulsquellen können auch (z. B. in Gruppen) entlang mehrerer Linien, auch z. B. nach Art eines Gitters, angeordnet sein.

In einer bevorzugten Ausführungsform sind die Pulsquellen gemeinsam in einer Ebene angeordnet. Insbesondere gilt dies zusammen mit der o. g. Linienanordnung. Die Ebene verläuft insbesondere quer zur oben erläuterten Zentralrichtung des Generators. Auch dies stellt eine besonders einfache und effektive Quellenstruktur bzw. ein flächiges Array dar.

Gemäß der Erfindung (oder zum o. g. durchgehenden Innenraum alternativ) enthält der Generator mindestens eine Trennwand, weist also insbesondere keinen durchgehenden Innenraum auf. Durch jede der Trennwände sind jeweilige Einzelkanäle für Pulsanteile gebildet bzw. voneinander getrennt. In jedem der Einzelkanäle ist mindestens eine der Pulsquellen enthalten. Jeder der Einzelkanäle weist eine jeweilige Kanalöffnung zur Abstrahlung der jeweiligen Pulsanteile der jeweiligen Pulsquellen auf. Die Pulsanteile mehrerer Einzelquellen eines Einzelkanales sind an der Kanalöffnung des betreffenden Kanales bereits zumindest teilweise einander überlagert, wenn mindestens zwei Pulsquellen in einem der Einzelkanäle enthalten sind. Insbesondere enthält jeder Einzelkanal genau eine der Pulsquellen. Insbesondere ist mindestens einer der Kanäle, insbesondere alle Kanäle, als (insbesondere oben erläuterte) Wellenleiter ausgebildet. So kann eine gezielte Pulsformung bereits innerhalb des Generators erfolgen.

In einer bevorzugten Variante dieser Ausführungsform ist die Generatoröffnung aus der Summe der Kanalöffnungen gebildet. Somit ergibt sich eine besonders effektive Ausnutzung der Generatoröffnung bzw. eine platzsparende Bauweise für den Generator.

In einer bevorzugten Variante dieser Ausführungsform ist mindestens einer der Einzelkanäle ein zylinderförmiger Kanal. Die Zylinderform weist insbesondere einen rechteckigen, quadratischen, runden oder kreisförmigen Querschnitt auf und/oder ist gerade oder variiert im Durchmesser. Dies gilt insbesondere entlang einer Richtung auf die Kanalöffnung zu. Derartige Kanalformen haben sich als besonders günstig für HPEM-Anwendungen erwiesen.

Gemäß der Erfindung weist mindestens einer der Einzelkanäle einen hornförmigen Teilabschnitt auf. Auch hier gelten die o. g. Aussagen in Bezug auf bekannte Hörner. Die bekannten Vorteile einer Hornstruktur ergeben sich somit auch bereits für den jeweiligen Einzelkanal.

In einer bevorzugten Ausführungsform schließt der hornförmige Teilabschnitt an die Kanalöffnung an. Der Teilabschnitt ist also ausgangsseitig im Teilkanal vorhanden, d. h. mündet in die jeweilige Kanalöffnung. Insbesondere ergibt sich so eine kombinierte Hornform, welche bereits in wenigstens einem der Teilkanäle beginnt und sich dann in der gemeinsamen eigentlichen Hornstruktur fortsetzt.

Die Aufgabe der Erfindung wird auch gelöst durch eine Strahlungseinrichtung nach Anspruch 12. Diese enthält eine erfindungsgemäße Strahlungsquelle und eine Steuereinrichtung zur zeitlich synchronisierten Auslösung der Pulsquellen zur jeweiligen Aussendung eines Pulsanteils. Die zeitliche Synchronisierung kann hierbei in einer Gleichzeitigkeit der Auslösung mindestens zweier oder aller Pulsquellen bestehen. Alternativ oder zusätzlich kann auch eine zeitversetzte Auslösung mindestens zweier oder aller Pulsquellen erfolgen. So kann in herkömmlicher bzw. in der Praxis üblicher Weise eine Phasensteuerung der Pulsquellen erfolgen. Dies kann zu einer Amplitudenerhöhung im Puls führen und/oder zu einer gesteuerten Änderung der Richtung, in der der Puls von der Strahlungsquelle abgestrahlt wird.

Ansonsten wurde die Strahlungseinrichtung und zumindest ein Teil deren Ausführungsformen sowie die jeweiligen Vorteile sinngemäß bereits im Zusammenhang mit der erfindungsgemäßen Strahlungsquelle erläutert.

Ein Verschwenken der resultierenden Abstrahlcharakteristik bei dem Array aus Mikrowellen-Generatoren ist z. B. aus der EP 1 947 464 B1 bekannt.

Die Erfindung beruht auf folgenden Erkenntnissen, Beobachtungen bzw. Überlegungen und weist noch die nachfolgenden Ausführungsformen auf. Die Ausführungsformen werden dabei teils vereinfachend auch "die Erfindung" genannt. Die Ausführungsformen können hierbei auch Teile oder Kombinationen der oben genannten Ausführungsformen enthalten oder diesen entsprechen und/oder gegebenenfalls auch bisher nicht erwähnte Ausführungsformen einschließen.

Die Erfindung beruht auf der Idee, die Leistung und Reichweite von HPEM Wirksystemen bei gleichzeitiger Reduzierung/Erhaltung der Größe des Wirksystems zu steigern bzw. darauf, die "Leistungsdichte" von HPEM Wirksystemen im Allgemeinen zu steigern.

Die Erfindung beruht auf der Überlegung, dass die Reichweite und Leistung von HPEM System durch folgende Verfahren erhöht werden könnten:
1. Erhöhung der Leistung des Einzelresonators/-systems durch Erhöhung der Spannungs-/Feldamplitude.
2. Erhöhung der Reichweite und Richtwirkung eines Einzelsystems durch Verwendung von direktiven Antennen-Systemen, Reflektor-Systemen oder Hornantennen.
3. Anwendung des Array-Prinzips: Verwendung mehrerer parallel geschalteter DS-Resonatoren/Antennenstäbe in einer Ebene, die zeitlich synchron arbeiten. Bei synchronem Betrieb erhöht sich die Reichweite und Richtung (Bündelung) entsprechend dem Array-Prinzip (Array-Faktor). Im phasengesteuerten Betrieb kann bei der richtigen Ansteuerung der Phasen der einzelnen Resonatoren zueinander ein Beam-Steering (elektronische Ablenkung/Nachführung des Strahles) realisiert werden. Eine Erhöhung der Reichweite bedingt eine Erhöhung der Anzahl der abstrahlenden Antennenelemente und damit eine Vergrößerung der abstrahlenden Antennenapertur.
4. Anwendung von Horn-Antennen: Durch die Anwendung einer Hornantennen-Struktur mit einem Dipol oder einer kurzen Stabantenne (Stub) als abstrahlendes Element in der Hornantenne, lässt sich die Bündelung und Fokussierung des HPEM Strahls deutlich verbessern und damit eine erhebliche Verbesserung der Reichweite (Gain) gegenüber der Verwendung einer einfachen Dipolantenne oder einer Dipolantenne mit einfachem Reflektor erzielen. Eine Steigerung der Reichweite bedingt eine Vergrößerung der eingekoppelten Leistung in den Antennen-Dipol/Antennen-Stub, der abstrahlenden Antennenfläche (Aperturfläche am Horn) und/oder der Länge der Hornstruktur.

Weiter beruht die Erfindung auf der Überlegung, dass folgende Vorgehen denkbar sind:
Array-Prinzip:
   Steigerung der Reichweite und elektronische Phasen-Steuerung (Beam Steering) des Strahlungsfeldes durch Phasen-synchrone oder Phasen-gesteuerte Abstrahlung der einzelnen Antennen (Resonatoren/Stubs/Monopole/Dipole) im Array. Die Erhöhung der Reichweite skaliert mit der Größe des Arrays (Array-Wirkfläche/abstrahlende Fläche) und der Anzahl der verwendeten Antennen/Resonatoren im Array.
Horn-Antennen-Prinzip:
   Durch Einspeisung der elektromagnetischen Welle bzw. des Pulses durch einen Antennen-Stub/Dipol/Resonator/Monopol in eine Hornstruktur, können Verstärkungsfaktoren in Abstrahlrichtung von bis zu mehreren 10 dB realisiert werden. Dies hängt ab von der Größe der abstrahlenden Fläche (Apertur) und der Ausleuchtung/Belegung dieser Apertur, die auch durch den Öffnungswinkel des Horns und die Hornlänge bestimmt wird. Je stärker die Bündelung und Fokussierung durch die Hornstruktur, desto größer ist die Reichweite des elektromagnetischen Signals.

Die Erfindung beruht auf folgender Idee:
Durch die Verbindung/Kombination der Array-Technologie mit der Horn-Antennen-Technologie wird die eingekoppelte, respektive die abgestrahlte Leistung und Reichweite bei gleichgebliebenen Abmessungen der Horn-Apertur/(-Struktur) deutlich erhöht. Durch die Integration eines Antennen-Arrays in einen Antennen-Waveguide, der sich direkt an das Horn anschließt, und damit in das Antennen-Horn, werden beide Effekte miteinander kombiniert und die eingekoppelte Leistung im Horn, respektive die abgestrahlte Leistung, lässt sich deutlich erhöhen. Die von den einzelnen Resonatoren/Antennen/Stubs im Array abgestrahlten Wellenfronten überlagern sich konstruktiv im Innenbereich des Waveguides bzw. der Hornstruktur. Die Dimensionen des Waveguides und der Hornstruktur sind dabei entsprechend den abzustrahlenden Frequenzen/Wellenlängen, der Anzahl und dem Abstand der Resonatoren voneinander sowie auch von den Wänden des Waveguides respektive des Horns aufeinander abgestimmt. Auch kann für jeden einzelnen Resonator im Waveguide/Horn-Array ein eigener Waveguide verwendet werden. Auch hier sind die Dimensionen des/der Waveguides auf die abgestrahlten Frequenzen und die Anzahl der Resonatoren, die Abstände zueinander und die Abstände zu den Wänden/Waveguide/Hornstruktur abgestimmt. Dadurch ergibt sich die Möglichkeit die Leistung eines Systems/Antennen-Horns mit vorgegebener Aperturfläche und/oder Länge deutlich zu steigern, indem über mehrere Resonatoren/Dipole/Monopole/Stubs in das Horn eingekoppelt wird. Wesentlich ist, dass dabei die Leistungsdichte des Systems (Leistungsdichte = eingekoppelte bzw. abgestrahlte Leistung pro Wirkfläche/Apertur (Horn) respektive pro Volumen (Horn)) erhöht wird. Zusätzlich zur Verwendung des Arrays im Waveguide/Horn kann z. B. auch die Apertur und/oder die gesamte Dimension des Horns vergrößert werden, um eine weitere Erhöhung der abgestrahlten Leistung bzw. der Leistungsdichte zu erzielen.

Abhängig von der Horn-Größe und der eingekoppelten/abgestrahlten Wellenlänge/Impulsform/Anstiegszeiten/Amplitude können auch mehrere (mehr als zwei) DS-Resonatoren/Stubs/Dipole/Monopole als DS-Array in einem Antennen-Horn untergebracht werden.

Gemäß der Erfindung ergibt sich somit ein HPEM DS Hochleistung-Horn-Array. Gemäß der Erfindung ergibt sich eine Steigerung der Reichweite und Leistung von HPEM- Systemen durch Kopplung des HPEM-Array- Prinzips mit einer HPEM-Hornantenne durch Integration mehrerer HPEM DS Resonatoren (HPEM DS Array) oder andere Antennenstrukturen (Stabantenne, die Pohl-Antenne) in eine oder mehrere HPEM Horn-Antennen-Struktur/en.

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen in einer schematischen Prinzipskizze:
- Figur 1: eine Strahlungseinrichtung mit Strahlungsquelle im Betrieb im seitlichen Schnitt, ohne das erfindungsgemäße Merkmal, dass mindestens einer der Einzelkanäle einen hornförmigen Teilabschnitt aufweist.
- Figur 2: eine alternative, nicht in allen Merkmalen erfindungsgemäße, Strahlungsquelle mit vier Pulsquellen im a) in einer Darstellung gemäß Fig. 1 und b)= in Frontansicht,
- Figur 3: eine alternative, nicht in allen Merkmalen erfindungsgemäße, Strahlungsquelle mit acht Pulsquellen in einer Darstellung gemäß Fig. 2b,
- Figur 4: alternative Strahlungsquellen mit mehreren Pulsquellen in a) Einzelkanälen mit hornförmigen Teilabschnitten, b) geraden Einzelkanälen und c) in einem durchgehenden Innenraum, jeweils in einer Darstellung gemäß Fig. 1. Nur die Variante in Fig 4a ist erfindungsgemäß.

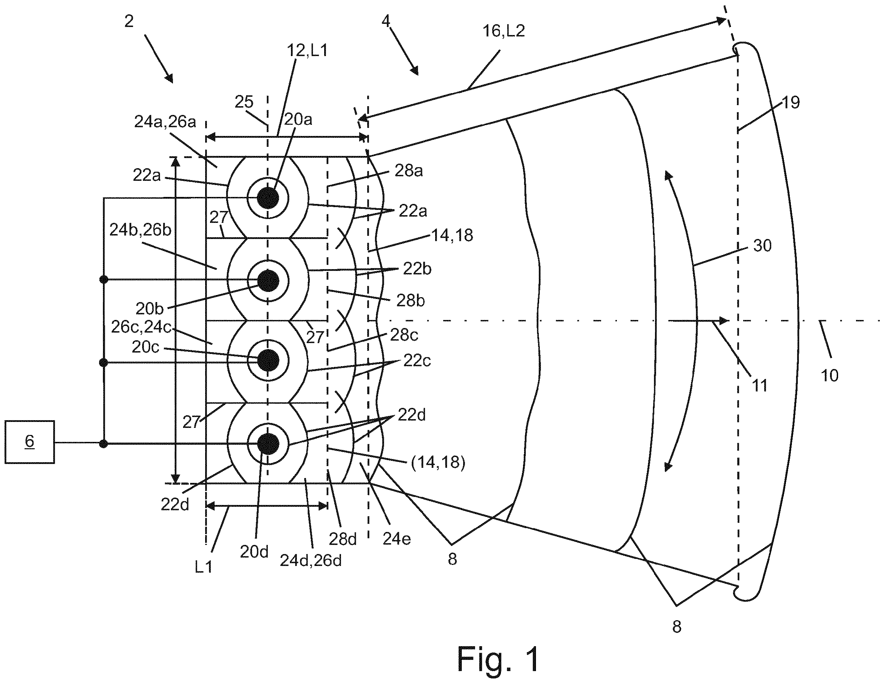

Figur 1 zeigt eine Strahlungseinrichtung 2, die eine Strahlungsquelle 4 und eine Steuereinrichtung 6 enthält. Die Strahlungsquelle 4 dient zur Abstrahlung eines elektromagnetischen HPEM-Mikrowellen-Pulses 8. Figur 1 zeigt die Strahlungseinrichtung 2 im Betrieb, wobei der Puls 8 in Form einer Wellenfront symbolisch angedeutet ist. Der Puls 8 wird dabei in einer Abstrahlrichtung 11 von der Strahlungsquelle 4 abgestrahlt. Die Abstrahlrichtung 11 stellt dabei einen Zentralstrahl für den Puls 8 dar. Die Abstrahlrichtung 11 verläuft hier parallel zur Zentralrichtung 10 - hier eine Gerade bzw. Mittellängsachse - der Strahlungseinrichtung 2.

Die Strahlungsquelle 4 enthält einen Mikrowellen-Generator 12 zur Erzeugung des Pulses 8. Der Generator 12 weist dabei eine gestrichelt angedeutete Generatoröffnung 14 auf, durch welche der Puls 8 im Betrieb aus dem Generator 12 abgestrahlt wird.

Die Strahlungsquelle 4 enthält außerdem eine Hornstruktur 16 zur Formung des Pulses 8. Die Hornstruktur 16 weist eine Eingangsöffnung 18 auf, die mit der Generatoröffnung 14 verbunden ist, im Beispiel mit der Generatoröffnung 14 zusammenfällt. Die Eingangsöffnung 18 dient zur Einstrahlung des Pulses 8 in die Hornstruktur 16. Die Hornstruktur 16 weist außerdem eine gestrichelt angedeutete Abstrahlungsöffnung 19 auf, die zur Abstrahlung des geformten Pulses 8 aus der Hornstruktur 16 und damit aus der Strahlungsquelle 4 dient. Die Hornstruktur besteht hier aus vier trapezförmigen Ebenen, die zusammen ein Horn mit rechteckigem Querschnitt bilden, das sich zur Abstrahlöffnung 19 hin konisch erweitert.

Der Generator 12 enthält im Beispiel vier Pulsquellen 20a bis 20d; diese bilden zusammen ein Array. Jede der Pulsquellen 20a bis 20d ist eine Antenne bzw. ein Resonator und dient zur jeweiligen Erzeugung eines Pulsanteils 22a bis 22d. Jeder der Pulsanteile 22a bis 22d ist ebenfalls durch Wellenfronten in Figur 1 symbolisiert. Der Puls 8 ist die Summe bzw. Überlagerung der Pulsanteile 22a bis 22d. Die Summe wird durch Superposition der Wellenfronten gebildet.

Der Generator 12 enthält im Beispiel vier Wellenleiter 24a bis 24d bzw. Waveguides. In jedem der Wellenleiter 24a bis 24d ist eine der Pulsquellen 20a bis 20d angeordnet. Die Pulsquellen 20a bis 20d sind im Generator 12 als Linien-Array entlang einer Linie 25, hier einer Geraden, angeordnet. Jeder der Wellenleiter 24a bis 24d dient zur Führung eines der Pulsanteile 22a bis 22d, die jeweils innerhalb des Wellenleiters 24a bis 24d erzeugt werden. Die Wellenleiter 24a bis 24d stellen jeweilige Einzelkanäle 26a bis 26d dar. Der Generator 12 enthält drei Trennwände 27, um die Einzelkanäle 26a bis 26d voneinander zu trennen. Somit ist auch in jedem der Einzelkanäle 26a bis 26d eine jeweilige der Pulsquellen 20a bis 20d angeordnet bzw. enthalten. Jeder Einzelkanal 26a bis 26d weist eine jeweilige Kanalöffnung 28a bis 28d auf, die zur Abstrahlung des jeweiligen Pulsanteils 22a bis 22d der jeweiligen Pulsquelle 20a bis 20d dient. Sämtliche Einzelkanäle 26a bis 26d sind Zylinderförmige, hier mit rechteckigen Querschnitt und als gerade Zylinder mit gleichmäßigem Querschnitt ausgeführt.

Die Wellenleiter 24a bis 24d münden mit ihren jeweiligen Ausgangsöffnungen (Kanalöffnungen 28a bis 28d) in einen weiteren Wellenleiter 24e des Generators 12. Auch dieser weist eine gerade Zylinderform mit rechteckigem Querschnitt auf. In diesem und in der anschließenden Hornstruktur 16 findet die Summation bzw. Überlagerung der Pulsanteile 22a bis 22d zum Puls 8 statt. Der Wellenleiter 24e weist als Eingangsöffnung die Summe der Ausgangsöffnungen der Wellenleiter 24a bis 24d auf und als Ausgangsöffnung die Generatoröffnung 14 auf.

In einer alternativen Betrachtungsweise wird der Wellenleiter 24e bereits als Teil der Hornstruktur 16 angesehen werden und gehört nicht mehr zum Generator 12. Generatoröffnung 14 und Eingangsöffnung 18 verschieben sich dann entgegen der Abstrahlrichtung 11 nach "hinten" und fallen mit den Kanalöffnungen 28a bis 28d zusammen. Mit anderen Worten bildet die Summe der Kanalöffnungen 28a bis 28d die Generatoröffnung 14 und die Eingangsöffnung 18. Dies ist in Figur 1 in Klammern angedeutet.

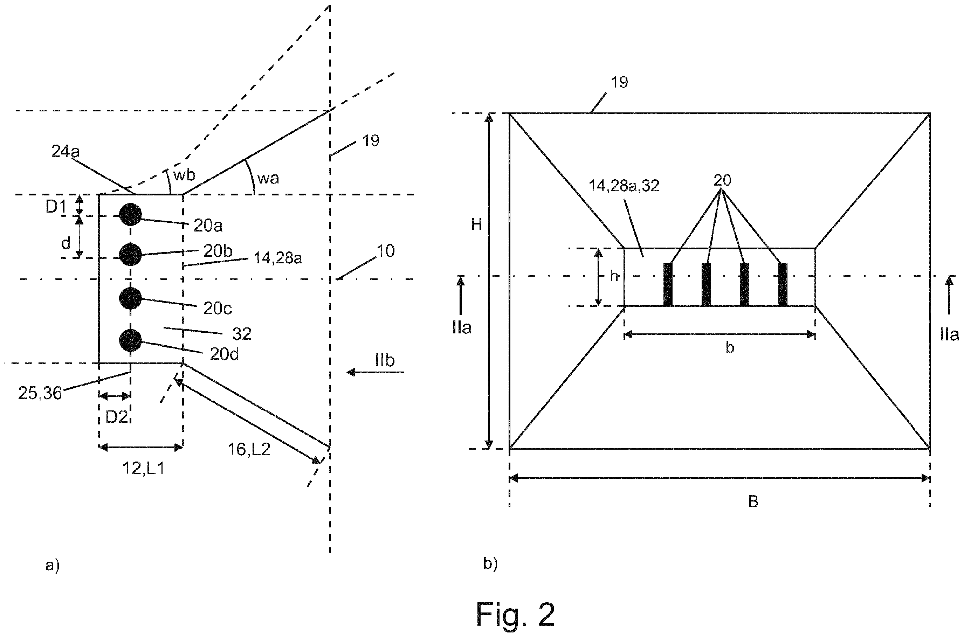

Generell sind im Rahmen des Designs bzw. der Konstruktion bzw. Dimensionierung der Strahlungsquelle 4 unter anderem die Länge L1 des Generators 12 (bzw. Teillängen der Wellenleiter 24a bis 24e) sowie die Länge L2 der Hornstruktur 16 variierbar; siehe hierzu auch Figuren 2 bis 4 mit Erläuterungen.

Die Steuereinrichtung 6 dient zur zeitlich synchronisierten Auslösung der Pulsquellen 20a bis 20d zur jeweiligen Aussendung eines Pulsanteils 22a bis 22d. Die Auslösung erfolgt dabei insbesondere zeitgleich, um die Intensität des Pulses 8 zu steigern oder phasengesteuert zu unterschiedlichen Auslösezeiten, um die Abstrahlrichtung 10 in Richtung des Doppelpfeils 30 zu variieren bzw. zu verschwenken.

Figur 2 zeigt eine alternative Strahlungsquelle 4, die im Wesentlichen gemäß der Strahlungsquelle 4 aus Figur 1 aufgebaut ist. Unterschiedlich ist jedoch, dass der Generator 12 einen nicht erfindungsgemäßen durchgehenden Innenraum 32 aufweist, d. h. keine Trennwände 27 enthält und somit keine Einzelkanäle 26 gebildet sind. Vielmehr ist der Generator 12 als einziger Wellenleiter 24a mit Kanalöffnung 28a ausgeführt. Im Innenraum 32 sind alle vier Pulsquellen 20a bis 20d wieder in Form eines Arrays entlang der Linie 25 bzw. Geraden angeordnet.

Weitere Designfreiheiten beim Entwurf der Strahlungsquelle 4 sind hier noch verdeutlicht. Variierbar sind:
- die Wandabstände D1 (seitlich, quer zur Zentralrichtung 10) und D2 (in Längsrichtung bzw. entlang der Zentralrichtung 10) zwischen Pulsquelle 20 und jeweiliger umgebender Wand des Generators 12,
- die Abstände d der Pulsquellen 20 untereinander,
- die Länge L1 des Generators in Zentralrichtung 10,
- die Länge L2 der Hornstruktur 16 (in Erstreckungsrichtung der Wandung der Hornstruktur 16),
- die Anzahl der Pulsquellen 20 (zwei bis n),
- der Öffnungswinkel wb der Seitenwände des Generators 12,
- der Öffnungswinkel wa der Hornstruktur 16,
- Breite b und Höhe h des Generators 12 bzw. Wellenleiters 24a bzw. der Generatoröffnung 14,
- Breite B und Höhe H der Hornstruktur 16 bzw. des eigentlichen konischen Horns bzw. der Abstrahlöffnung 19,
- die Abstände der einzelnen Pulsquellen zur zugehörigen Kanalöffnung,
- die Länge der einzelnen Waveguides, jedoch maximal L1.

Insbesondere Figur 2b ist zu entnehmen, dass sowohl der Generator 12 als auch die Hornstruktur 16 bezüglich der Zentralrichtung 10 einen eckigen, hier rechteckigen, Querschnitt aufweisen. Auch ist hier zu erkennen, dass der Innenraum 32 daher kistenartig bzw. als Quaderform ausgebildet ist.

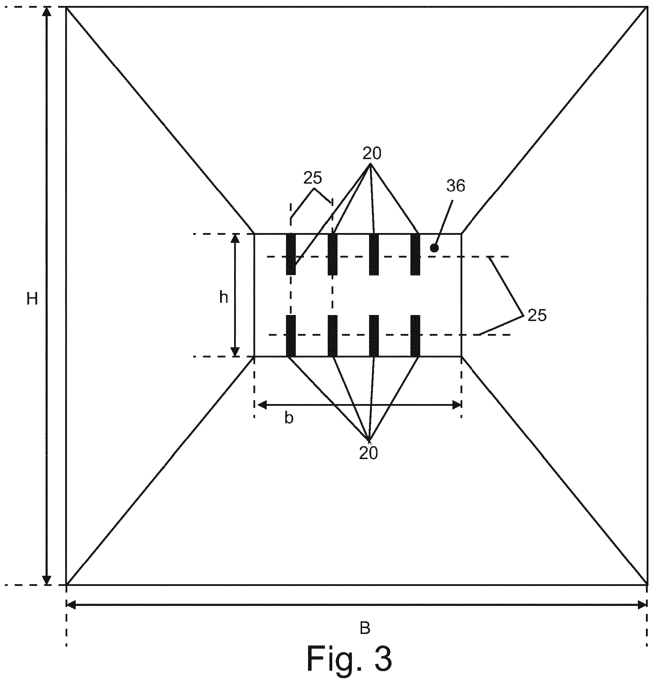

Figur 3 zeigt exemplarisch eine alternative Strahlungsquelle 4 aus Figur 2, jedoch variiert in verschiedenen Parametern (B, H, b), insbesondere der Höhe h des Wellenleiters 24a und der Anzahl von n=acht statt n=vier Pulsquellen 20. In Figur 3 sind außerdem die Pulsquellen 20 in zwei Vierergruppen jeweils entlang von Linien 25, und auch in einer (in Figur 2a symbolisch verdeutlichten) gemeinsamen Ebene 36 angeordnet.

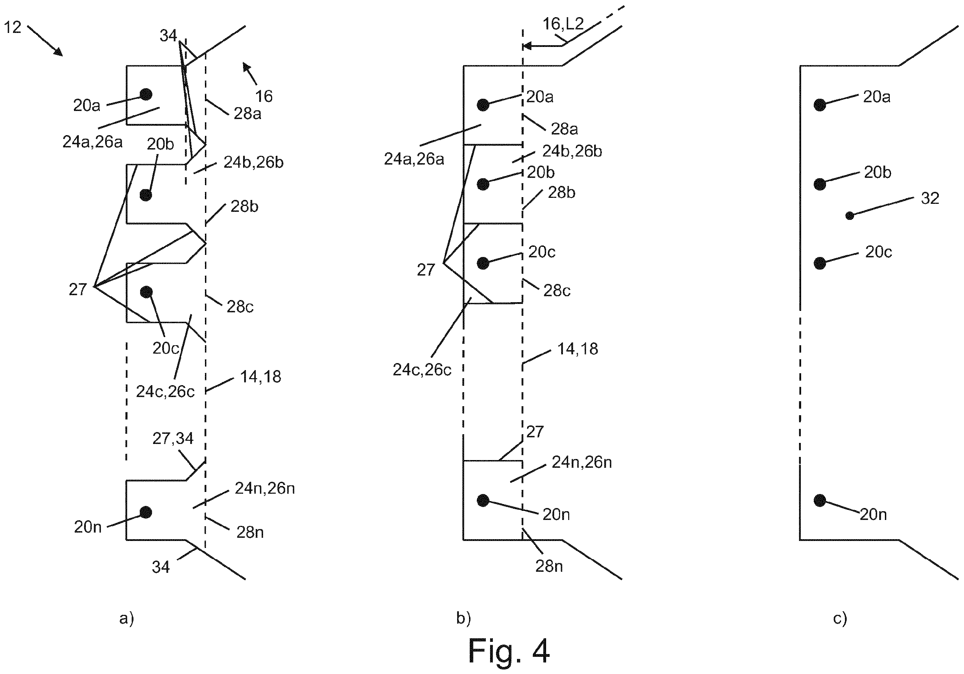

Figur 4 zeigt weitere alternative Strahlungsquellen 4 mit folgenden Designvariationen: Die Hornstruktur 16 ist jeweils nur verkürzt angedeutet. Figur 4a zeigt symbolisch für eine allgemeine Anzahl von n (größer oder gleich zwei) Pulsquellen 20 jeweilige Einzelkanäle 26a bis 26n bzw. Wellenleiter 24a bis 24n, die erfindungsgemäß einen jeweiligen hornförmigen Teilabschnitt 34 aufweisen (durch gestrichelte Linien für die Einzelkanäle 26a, 26b angedeutet), der an die jeweilige Kanalöffnung 28a bis 28n anschließt. Mit anderen Worten endet der jeweilige Einzelkanal 26a bis 26n mit einem hornförmigen Endabschnitt (Teilabschnitt 34) an der jeweiligen Kanalöffnung 28a bis 28n. Die Generatoröffnung 14 ist wieder als Summe der Kanalöffnungen 28a bis 28n gebildet. Die Hornstruktur 16 schließt sich nahtlos und im gleichen Winkel an die außenseitigen Teilabschnitte 34 der Einzelkanäle 26a, 26n an.

Figur 4b zeigt eine nicht erfindungsgemäße Variation zu Figur 4a, bei der keine hornförmigen Teilabschnitte 34 vorhanden sind, sondern die Einzelkanäle 26a bis 26n in Form von geraden Zylindern ausgeführt sind. Hier ist das Horn außerdem aus einem geraden und einem konischen Abschnitt gebildet, weshalb die Generatoröffnung 14 und Eingangsöffnung 18 entgegen der Zentralrichtung 10 im Vergleich zu Fig. 4a "zurückversetzt" ist.

Figur 4c zeigt eine ebenfalls nicht erfindungsgemäße Variation zu Figur 4b, bei der die Trennwände 27 weggelassen sind weshalb sich ein nicht erfindungsgemäßer durchgehender Innenraum 32 ergibt, in dem alle Pulsquellen 20 angeordnet sind.

### Bezugszeichenliste

- 2: Strahlungseinrichtung
- 4: Strahlungsquelle
- 6: Steuereinrichtung
- 8: Puls
- 10: Zentralrichtung
- 11: Abstrahlrichtung
- 12: Generator
- 14: Generatoröffnung
- 16: Hornstruktur
- 18: Eingangsöffnung
- 19: Abstrahlöffnung
- 20a bis 20n: Pulsquelle
- 22a bis 22d: Pulsanteil
- 24a bis 24n: Wellenleiter
- 25: Linie
- 26a bis 26n: Einzelkanal
- 27: Trennwand
- 28a bis 28n: Kanalöffnung
- 30: Doppelpfeil
- 32: Innenraum
- 34: Teilabschnitt
- 36: Ebene

- L1: Länge (Wellenleiter/Generator)
- L2: Länge (Wellenleiter/Hornstruktur)
- D1, D2: Wandabstand
- wa, wb: Öffnungswinkel
- b, h: Breite, Höhe (Wellenleiter)
- B, H: Breite, Höhe (Hornstruktur)

## Patentansprüche

1. Strahlungsquelle (4) zur Abstrahlung eines elektromagnetischen HPEM-Mikrowellen-Pulses (8),
- mit einem Mikrowellen-Generator (12) zur Erzeugung des Pulses (8), wobei der Generator (12) eine Generatoröffnung (14) zur Ausgabe des Pulses (8) aufweist, und
- mit einer Hornstruktur (16) zur Formung des Pulses (8), die eine mit der Generatoröffnung (14) verbundene Eingangsöffnung (18) zur Einstrahlung des Pulses (8) und eine Abstrahlöffnung (19) zur Abstrahlung des geformten Pulses (8) aufweist,
- wobei der Generator (12) mindestens zwei Pulsquellen (20a bis 20n) zur jeweiligen Erzeugung eines Pulsanteils (22a bis 22n) enthält, wobei der Puls (8) die Summe der Pulsanteile (22a bis 22n) ist,
- wobei der Generator (12) mindestens eine Trennwand (27) enthält, wobei durch jede der Trennwände (27) jeweilige Einzelkanäle (26a bis 26n) voneinander getrennt sind, wobei in jedem der Einzelkanäle (26a bis 26n) mindestens eine der Pulsquellen (20a bis 20n) enthalten ist, wobei jeder der Einzelkanäle (26a bis 26n) eine jeweilige Kanalöffnung (28a bis 28n) zur Abstrahlung der jeweiligen Pulsanteile (22a bis 22n) der jeweiligen Pulsquellen (20a bis 20d) aufweist,
- wobei die Strahlungsquelle **dadurch gekennzeichnet ist, dass** mindestens einer der Einzelkanäle (26a bis 26n) einen hornförmigen Teilabschnitt (34) aufweist.

2. Strahlungsquelle (4) nach Anspruch 1,
**dadurch gekennzeichnet,**
**dass** die Pulsquelle (20a bis 20n) einen Resonator und/oder eine Antenne und/oder einen Stub zur Erzeugung des Pulsanteils (22a bis 22n) enthält oder ist.

3. Strahlungsquelle (4) nach einem der vorhergehenden Ansprüche,
**dadurch gekennzeichnet,**
**dass** der Generator (12) und/oder die Hornstruktur (16) mindestens einen Wellenleiter (24a bis 24n) zur Führung der Pulsanteile (22a bis 22n) und/oder des Pulses (8) und/oder zur Summation der Pulsanteile (22a bis 22n) enthalten.

4. Strahlungsquelle (4) nach Anspruch 3,
**dadurch gekennzeichnet,**
**dass** mindestens eine der Pulsquellen (20a bis 20n) in einem der Wellenleiter (24a bis 24n) angeordnet ist.

5. Strahlungsquelle (4) nach einem der vorhergehenden Ansprüche,
**dadurch gekennzeichnet,**
**dass** der Generator (12) und/oder die Hornstruktur (16) - und/oder, falls vorhanden, mindestens einer der Wellenleiter (24a bis 24n) - bezüglich einer Zentralrichtung (10) der Strahlungsquelle (4) einen eckigen Querschnitt aufweist.

6. Strahlungsquelle (4) nach einem der vorhergehenden Ansprüche,
**dadurch gekennzeichnet,**
**dass** der Generator (12) bezüglich seines Innenraumes (32) topf- oder kistenartig ausgebildet ist.

7. Strahlungsquelle (4) nach einem der vorhergehenden Ansprüche,
**dadurch gekennzeichnet,**
**dass** die Pulsquellen (20a bis 20n) entlang einer Linie (25) im Generator (12) angeordnet sind.

8. Strahlungsquelle (4) nach einem der vorhergehenden Ansprüche,
**dadurch gekennzeichnet,**
**dass** die Pulsquellen (20a bis 20n) gemeinsam in einer Ebene (36) angeordnet.

9. Strahlungsquelle (4) nach einem der vorhergehenden Ansprüche,
**dadurch gekennzeichnet,**
**dass** die Generatoröffnung (14) aus der Summe der Kanalöffnungen (28a bis 28n) gebildet ist.

10. Strahlungsquelle (4) nach einem der vorhergehenden Ansprüche,
**dadurch gekennzeichnet,**
**dass** mindestens einer der Einzelkanäle (26a bis 26n) ein zylinderförmiger Kanal ist.

11. Strahlungsquelle (4) nach einem der vorhergehenden Ansprüche,
**dadurch gekennzeichnet,**
**dass** der hornförmige Teilabschnitt (34) mindestens eines der Einzelkanäle an die Kanalöffnung (28a bis 28n) anschließt.

12. Strahlungseinrichtung (2), mit einer Strahlungsquelle (4) nach einem der vorhergehenden Ansprüche, und mit einer Steuereinrichtung (6) zur zeitlich synchronisierten Auslösung der Pulsquellen (20a bis 20n) zur jeweiligen Aussendung eines Pulsanteils (22a bis 22n).

## Claims

1. Radiation source (4) for emitting an electromagnetic HPEM microwave pulse (8),
- having a microwave generator (12) for generating the pulse (8), wherein the generator (12) has a generator opening (14) for outputting the pulse (8), and
- having a horn structure (16) for shaping the pulse (8), which horn structure has an input opening (18), which is connected to the generator opening (14) and is intended to radiate in the pulse (8), and an emission opening (19) for emitting the shaped pulse (8),
- wherein the generator (12) contains at least two pulse sources (20a to 20n) for respectively generating a pulse component (22a to 22n), wherein the pulse (8) is the sum of the pulse components (22a to 22n),
- wherein the generator (12) contains at least one separating wall (27), wherein respective individual channels (26a to 26n) are separated from one another by each of the separating walls (27), wherein at least one of the pulse sources (20a to 20n) is contained in each of the individual channels (26a to 26n), wherein each of the individual channels (26a to 26n) has a respective channel opening (28a to 28n) for emitting the respective pulse components (22a to 22n) from the respective pulse sources (20a to 20d),
- wherein the radiation source is **characterized in that** at least one of the individual channels (26a to 26n) has a horn-shaped section (34).

2. Radiation source (4) according to Claim 1,
**characterized**
**in that** the pulse source (20a to 20n) contains or is a resonator and/or an antenna and/or a stub for generating the pulse component (22a to 22n).

3. Radiation source (4) according to one of the preceding claims,
**characterized**
**in that** the generator (12) and/or the horn structure (16) contain(s) at least one waveguide (24a to 24n) for guiding the pulse components (22a to 22n) and/or the pulse (8) and/or for summing the pulse components (22a to 22n).

4. Radiation source (4) according to Claim 3,
**characterized**
**in that** at least one of the pulse sources (20a to 20n) is arranged in one of the waveguides (24a to 24n).

5. Radiation source (4) according to one of the preceding claims,
**characterized**
**in that** the generator (12) and/or the horn structure (16) - and/or at least one of the waveguides (24a to 24n) if present - has/have a square cross section with respect to a central direction (10) of the radiation source (4).

6. Radiation source (4) according to one of the preceding claims,
**characterized**
**in that** the generator (12) has a pot-like or box-like design with respect to its interior (32).

7. Radiation source (4) according to one of the preceding claims,
**characterized**
**in that** the pulse sources (20a to 20n) are arranged along a line (25) in the generator (12).

8. Radiation source (4) according to one of the preceding claims,
**characterized**
**in that** the pulse sources (20a to 20n) are arranged together in a plane (36).

9. Radiation source (4) according to one of the preceding claims,
**characterized**
**in that** the generator opening (14) is formed from the sum of channel openings (28a to 28n).

10. Radiation source (4) according to one of the preceding claims,
**characterized**
**in that** at least one of the individual channels (26a to 26n) is a cylindrical channel.

11. Radiation source (4) according to one of the preceding claims,
**characterized**
**in that** the horn-shaped section (34) of at least one of the individual channels adjoins the channel opening (28a to 28n).

12. Radiation device (2) having a radiation source (4) according to one of the preceding claims and having a control device (6) for the temporally synchronized triggering of the pulse sources (20a to 20n) to respectively emit a pulse component (22a to 22n).

## Revendications

1. Source de rayonnement (4) destinée à émettre une impulsion micro-onde électromagnétique HPEM (8), ladite source de rayonnement comprenant
- un générateur de micro-ondes (12) destiné à générer l'impulsion (8), le générateur (12) comportant une ouverture de générateur (14) destinée à délivrer l'impulsion (8), et
- une structure en cornet (16) destinée à mettre en forme l'impulsion (8), laquelle structure comporte une ouverture d'entrée (18) reliée à l'ouverture de générateur (14) et destinée au rayonnement entrant de l'impulsion (8) et une ouverture de rayonnement sortant (19) destinée à rayonner en sortie l'impulsion (8) mise en forme,
- le générateur (12) contenant au moins deux sources d'impulsions (20a à 20n) destinées à générer chacune une composante d'impulsion (22a à 22n), l'impulsion (8) étant la somme des composantes d'impulsion (22a à 22n),
- le générateur (12) contenant au moins une paroi de séparation (27), chacune des parois de séparation (27) séparant des canaux individuels respectifs (26a à 26n) les uns des autres, chacun des canaux individuels (26a à 26n) contenant l'une au moins des sources d'impulsions (20a à 20n), chacun des canaux individuels (26a à 26n) comportant une ouverture de canal respective (28a à 28n) destinée à rayonner en sortie les composantes d'impulsions respectives (22a à 22n) des sources d'impulsions respectives (20a à 20d),
- la source de rayonnement étant **caractérisée en ce que** l'un au moins des canaux individuels (26a à 26n) comporte une portion (34) en forme de cornet.

2. Source de rayonnement (4) selon la revendication 1,
**caractérisée en ce que**
la source d'impulsions (20a à 20n) contient ou est un résonateur et/ou une antenne et/ou un tronçon destiné à générer la composante d'impulsion (22a à 22n).

3. Source de rayonnement (4) selon l'une des revendications précédentes,
**caractérisée en ce que**
le générateur (12) et/ou la structure en cornet (16) contien(nen)t au moins un guide d'onde (24a à 24n) destiné à guider les composantes d'impulsion (22a à 22n) et/ou l'impulsion (8) et/ou à faire la somme des composantes d'impulsion (22a à 22n).

4. Source de rayonnement (4) selon la revendication 3,
**caractérisée en ce que**
l'une au moins des sources d'impulsions (20a à 20n) est disposée dans l'un des guides d'ondes (24a à 24n).

5. Source de rayonnement (4) selon l'une des revendications précédentes,
**caractérisée en ce que**
le générateur (12) et/ou la structure en cornet (16) - et/ou, s'il est présent, l'un au moins des guides d'ondes (24a à 24n) - présente une section transversale angulaire par rapport à une direction médiane (10) de la source de rayonnement (4).

6. Source de rayonnement (4) selon l'une des revendications précédentes,
**caractérisée en ce que**
le générateur (12) est conçu quant à son espace intérieur (32) comme un pot ou une boîte.

7. Source de rayonnement (4) selon l'une des revendications précédentes,
**caractérisée en ce que**
les sources d'impulsions (20a à 20n) sont disposées le long d'une ligne (25) dans le générateur (12).

8. Source de rayonnement (4) selon l'une des revendications précédentes,
**caractérisée en ce que**
les sources d'impulsions (20a à 20n) sont disposées conjointement dans un plan (36).

9. Source de rayonnement (4) selon l'une des revendications précédentes,
**caractérisée en ce que**
l'ouverture de générateur (14) est formée de la somme des ouvertures de canal (28a à 28n).

10. Source de rayonnement (4) selon l'une des revendications précédentes,
**caractérisée en ce que**
l'un au moins des canaux individuels (26a à 26n) est un canal cylindrique.

11. Source de rayonnement (4) selon l'une des revendications précédentes,
**caractérisée en ce que**
la portion (34) en forme de cornet raccorde l'un au moins des canaux individuels à l'ouverture de canal (28a à 28n).

12. Dispositif de rayonnement (2) comprenant une source de rayonnement (4) selon l'une des revendications précédentes, et un dispositif de commande (6) destiné à déclencher de manière synchronisée dans le temps des sources d'impulsions (20a à 20n) destinées à émettre chacune une composante d'impulsion (22a à 22n).
